Europäisches Patentamt

European Patent Office

Office européen des brevets

(11) Numéro de publication: **0 340 713**

**A1**

## (12) DEMANDE DE BREVET EUROPEEN

(21) Numéro de dépôt: **89107915.4**

(51) Int. Cl.⁴: **H01P 5/12**

(22) Date de dépôt: **02.05.89**

(30) Priorité: **04.05.88 FR 8805993**

(43) Date de publication de la demande:
**08.11.89 Bulletin 89/45**

(84) Etats contractants désignés:
**AT BE CH DE ES FR GB IT LI NL SE**

(71) Demandeur: **ALCATEL CIT**
**33, rue Emeriau**
**F-75015 Paris(FR)**

(72) Inventeur: **Le Nohaic, Yves**
**Manoir de Kerdanet**
**F-22420 Plouaret(FR)**

(74) Mandataire: **Weinmiller, Jürgen et al**
**Lennéstrasse 9 Postfach 24**
**D-8133 Feldafing(DE)**

(54) **Dispositif de distribution de signaux numeriques a tres hauts debits.**

(57) Le dispositif de l'invention comporte un bus (B) constitué de tronçons de largeurs constantes et de longueurs quelconques. La largeur des tronçons du bus varie d'un tronçon à l'autre, le tronçon relié à un émetteur (E) ayant la plus grande largeur. Chaque jonction entre deux tronçons est reliée par une ligne en dérivation (L2 à Ln) à un dispositif électronique (D2 à Dn). Les lignes ont des longueurs quelconques même impédance caractéristique. Le tronçon extrême (B1) du bus est relié à un dispositif électronique (D1). Le tronçon extrême et les lignes sont chargés par une impédance égale à l'impédance caractéristique des lignes.

Dans le cas d'une distribution symétrique des signaux, la distribution se fait, à partir d'un émetteur différentiel (E'), par deux bus identiques (B, B') reliés par des lignes différentielles (Ld2 à Ldn) aux dispositifs électroniques (D'2 à D'n).

FIG.1

## Dispositif de distribution de signaux numériques à très hauts débits

L'invention est du domaine de la transmission de signaux numériques à très hauts débits et concerne la distribution de tels signaux par des lignes en dérivation sur une ligne de distribution.

Les débits des transmissions de signaux numériques peuvent atteindre actuellement des valeurs telles que le domaine des hyperfréquences est rejoint du point de vue des composantes spectrales.

Afin de conserver la forme des signaux transmis, il est impératif d'utiliser des supports de transmission parfaitement adaptés, la moindre connexion non adaptée pouvant être catastrophique du point de vue transmission.

Avec de très hauts débits, de l'ordre de 100 Mbit/s et au dessus, la longueur maximale tolérable d'une ligne mise en dérivation sur un bus est très courte, et fonction du débit, la longueur étant d'autant plus courte que le débit est élevé. Par exemple pour un débit de 100 Mbit/s, chaque ligne en dérivation sur un bus aura une longueur limitée à quelques centimètres car, même chargée sur son impédance caractéristique, elle entraîne une certaine désadaptation du bus. Au delà de cinq centimètres de longueur, une ligne dérivée amène une perturbation non acceptable des signaux numériques qu'elle transmet.

Dans le cas très courant de la distribution de signaux numériques à très hauts débits à des dispositifs électroniques portés par une même carte de circuit imprimé, cette longueur limitée des lignes impose de sévères contraintes d'implantation des dispositifs électroniques sur la carte, contraintes qui peuvent entraîner à limiter à un ou deux le nombre de dispositifs électroniques sur la carte alors même que celle-ci pourrait en recevoir davantage.

L'invention a pour but de permettre de distribuer, sans perturbation, des signaux numériques à très hauts débits par des lignes en dérivation sur un bus.

L'invention a également pour but de supprimer les contraintes d'implantation de dispositifs électroniques sur une même carte de circuit imprimé, contraintes dues aux très courtes longueurs des lignes en dérivation.

L'invention a pour objet un dispositif de distribution de signaux numériques à très hauts débits, comportant une ligne de distribution reliée à une extrémité à un émetteur et des lignes en dérivation ayant même impédance caractéristique et reliées chacune à un dispositif électronique, la ligne de distribution étant constituée par au moins un bus d'impédance variable, le bus étant constitué de n tronçons d'impédances différentes, chaque tronçon ayant une largeur constante, la largeur des tronçons successifs diminuant depuis l'extrémité du bus reliée à l'émetteur, chaque changement de largeur entre deux tronçons successifs constituant une jonction, et chaque ligne en dérivation étant reliée à une jonction, caractérisé par le fait que les lignes en dérivation ont des longueurs quelconques et que les tronçons des bus ont des longueurs quelconques.

L'invention sera bien comprise par la description qui va suivre d'exemples de réalisation illustrés par les figures annexées dans lesquelles :

- la figure 1 représente un dispositif de distribution de l'invention dans le cas d'une distribution asymétrique,

- la figure 2 A représente une variante du dispositif de distribution de la figure 1, la figure 2B représentant une variante d'un bus de la figure 2A,

- la figure 3 représente un dispositif de distribution de l'invention dans le cas d'une distribution symétrique,

- la figure 4 représente une variante du dispositif de distribution de la figure 3,

- la figure 5 représente une variante d'un dispositif électronique des figures 1 et 2,

- la figure 6 représente une variante d'un dispositif électronique des figures 3 et 4,

- la figure 7 représente une autre variante d'un dispositif électronique des figures 1 et 2,

- les figures 8A et 8B représentent deux autres variantes d'un dispositif électronique des figures 3 et 4,

- la figure 9 représente une variante d'un bus de la figure 2,

- la figure 10 représente, en perspective, une variante de deux bus de la figure 4.

- la figure 11 représente un dispositif de distribution asymétrique de l'invention utilisé en fond de panier,

- la figure 12 représente un dispositif de distribution symétrique de l'invention utilisé en fond de panier.

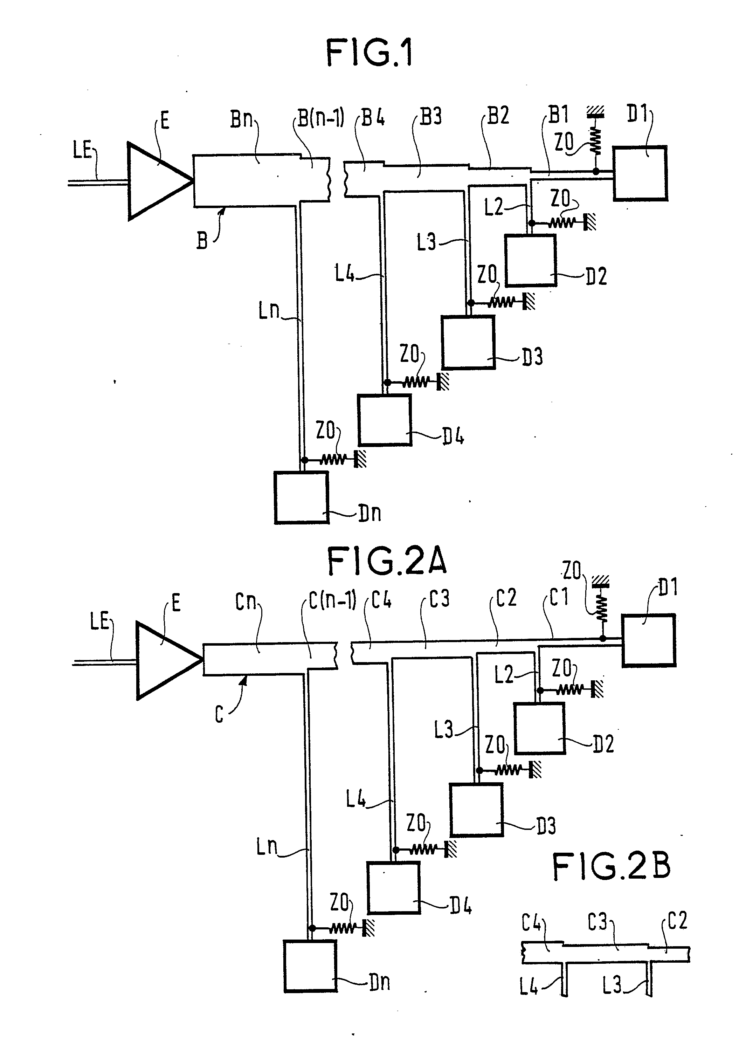

La figure 1 représente un dispositif de distribution de l'invention dans le cas d'une distribution asymétrique. Dans cette figure la ligne de distribution est un bus B à impédance variable relié à des lignes L2, L3,...Ln, de longueurs quelconques, ces lignes ayant toute une même impédance caractéristique Zo.

Le bus B est constitué de tronçons B1, B2,...Bn, le tronçon Bn étant relié à un émetteur E lui même relié en entrée à une ligne entrante LE, différentielle ou non, le tronçon B1 étant relié à un dispositif électronique D1. Chaque tronçon a une longueur quelconque et une largeur constante ; la largeur des tronçons augmente d'un tronçon à l'autre, le tronçon B1 ayant la plus petite largeur. Chaque jonction entre deux tronçons est obtenue par variation symétrique de la largeur d'un tronçon par rapport à sa longueur, cette variation ayant donc lieu de chaque côté des tronçons.

L'émetteur E, de tout type connu, assure la remise en forme des signaux numériques qu'il reçoit par la ligne entrante LE. Le bus B est un conducteur, tel par exemple qu'une piste de circuit imprimé, et les tronçons B1 à Bn ont des impédances Z1 à Zn, respectivement. A chaque jonction entre deux tronçons une ligne, L2,... Ln relie le bus à un dispositif électronique D2, D3,...Dn. A l'entrée de chaque dispositif électronique D2 à Dn, les lignes sont fermées sur leur impédance caractéristique Zo ; à l'entrée du dispositif électronique D1, l'extrémité du tronçon extrême B1 est fermée sur une impédance Z1, de préférence égale à Zo.

Pour obtenir une bonne transmission des signaux numériques, les tronçons sont fermés sur leur impédance ; les impédances des tronçons sont alors les suivantes :

$$Z2 = \frac{Zo \; Z1}{Zo+Z1}$$

$$Z3 = \frac{Zo \; Z2}{Zo+Z2}$$

$$et \quad Zn = \frac{Zo \; Z(n-1)}{Zo+Z(n-1)}$$

avec Z1 = Zo si le tronçon B1 a une impédance égale à Zo.

Si l'on prend Zo = 100 ohms on obtient Z1 = 100 ohms, Z2 = 50 ohms, Z3 = 33,3 ohms et Z4 = 25 ohms. Dans le cas de dispositifs électroniques D1, D2,...Dn en logique ECL, il est possible d'avoir une distribution vers quatre dispositifs électroniques, la valeur de 25 ohms étant une limite inférieure indiquée par les fabricants de circuits pour la charge en sortie des dispositifs électroniques.

La figure 2A représente une variante du dispositif de distribution de la figure 1. Dans cette figure, un des côtés longitudinaux du bus C est rectiligne, le changement de largeur entre deux tronçons successifs se faisant uniquement de l'autre côté longitudinal du bus. Comme dans la figure 1 les lignes L2, L3,...Ln sont reliées au bus à l'endroit des jonctions et fermées sur leur impédance caractéristique Zo ; le tronçon extrême C1, à l'extrémité du bus opposée à l'émetteur E relié au tronçon Cn, est relié à un dispositif électronique D1, ce tronçon C1 étant fermé sur une impédance Zo, comme dans le cas de la figure 1, en prenant Z1, impédance du tronçon C1, égale à Zo ; les valeurs des impédances Z2 à Zn des tronçons C2 à Cn sont données par les relations indiquées précédemment.

La figure 2B représente une variante de raccordement des lignes L2 à Ln au bus C de la figure 2A. Dans cette figure 2B les lignes sont raccordées au côté longitudinal du bus de distribution, en regard des décrochements qui constituent les jonctions entre les tronçons du bus de distribution.

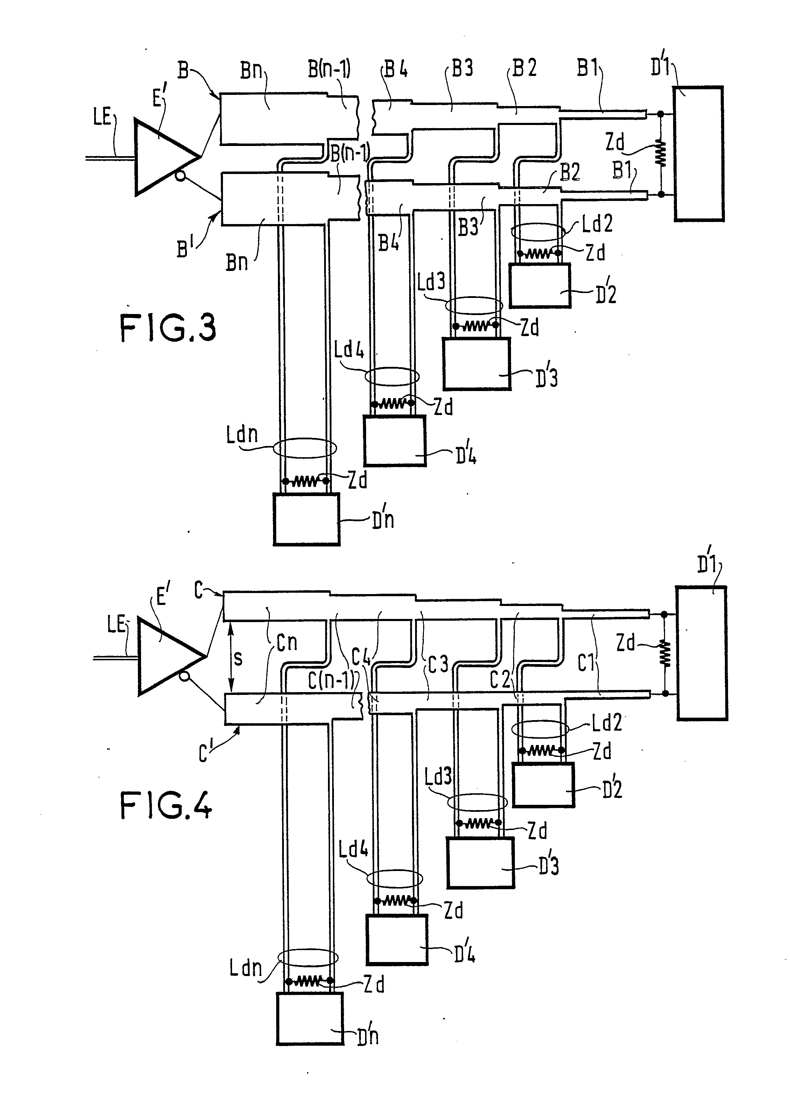

Les figures 3 et 4 représentent un dispositif de distribution de l'invention dans le cas d'une distribution symétrique ; dans ces figures la ligne de distribution est une ligne différentielle constituée par deux bus identiques B et B' ayant chacun une extrémité reliée en sortie d'un émetteur différentiel E' lui même relié en entrée à une ligne entrante LE, différentielle ou non.

Dans la figure 3 les deux bus B et B' sont du même type que le bus de distribution de la figure 1, c'est-à-dire que chaque jonction entre deux tronçons successifs d'un bus comporte un décrochement de chaque côté du bus de distribution. Dans la figure 4 les deux bus de distribution C et C' sont du même type que le bus de distribution de la figure 2, c'est-à-dire que chaque bus comporte un côté longitudinal rectiligne et que chaque jonction entre deux tronçons successifs est constituée par un décrochement sur l'autre côté longitudinal du bus. Dans la figure 4 les côtés longitudinaux rectilignes des bus de distribution C et C' sont en regard, et séparés par une distance constante s de quelques dixièmes de millimètres.

Des dispositifs électroniques D'2, D'3,...D'n, sont reliés chacun par une ligne différentielle Ld2, Ld3,...Ldn, aux jonctions homologues des deux bus de distribution B et B' ou C et C'. Les lignes différentielles Ld2 à Ldn ont des longueurs quelconques et même impédance ; elles sont donc fermées, à leur extrémité située en entrée des dispositifs électroniques, sur une impédance Zd égale à leur impédance caractéristique.

Dans ces deux figures la paire de tronçons extrêmes B1, ou C1 des deux bus de distribution est reliée à un dispositif électronique D'1, et est fermée sur une impédance égale à l'impédance de la paire de tronçons extrêmes qui de préférence est égale à l'impédance caractéristique Zd des lignes différentielles.

En désignant par Z1d, Z2d,...Znd, l'impédance correspondant respectivement aux deux tronçons homologues B1, B2,...Bn, figure 3, ou C1, C2,...Cn, figure 4, on a :

$$Z2d = \frac{Zd \cdot Z1d}{Zd+Z1d}$$

$$Z3d = \frac{Zd \cdot Z2d}{Zd+Z2d}$$

$$Znd = \frac{Zd \cdot Z(n-1)d}{Z1+Z(n-1)d}$$

avec $Z1d = Zd$ si la paire de tronçons B1 ou C1 a une impédance égale à $Zd$.

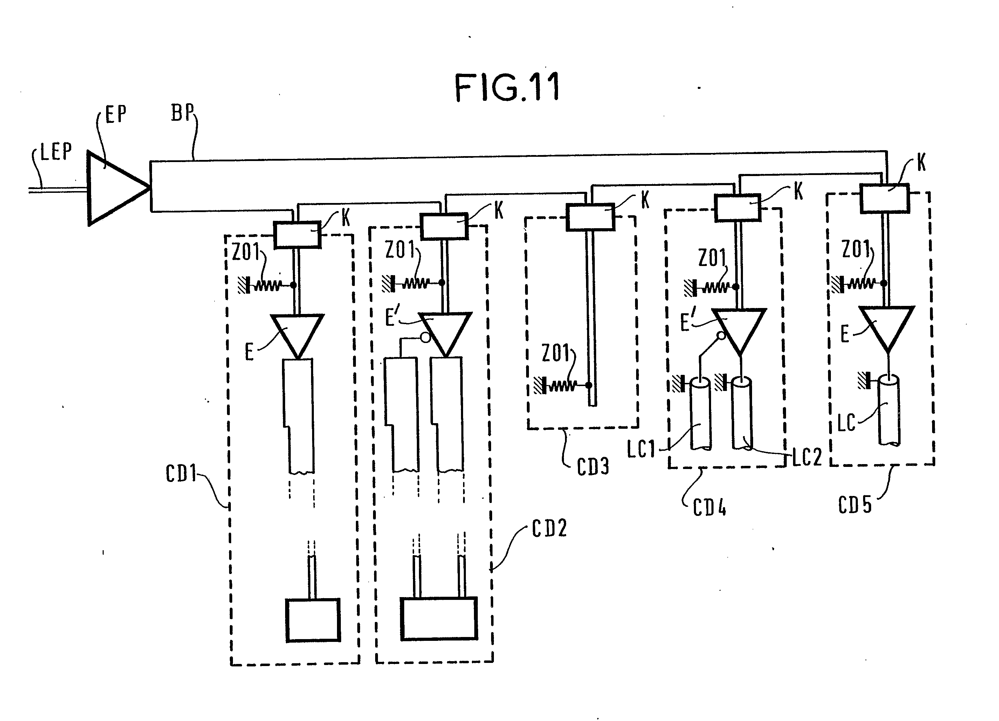

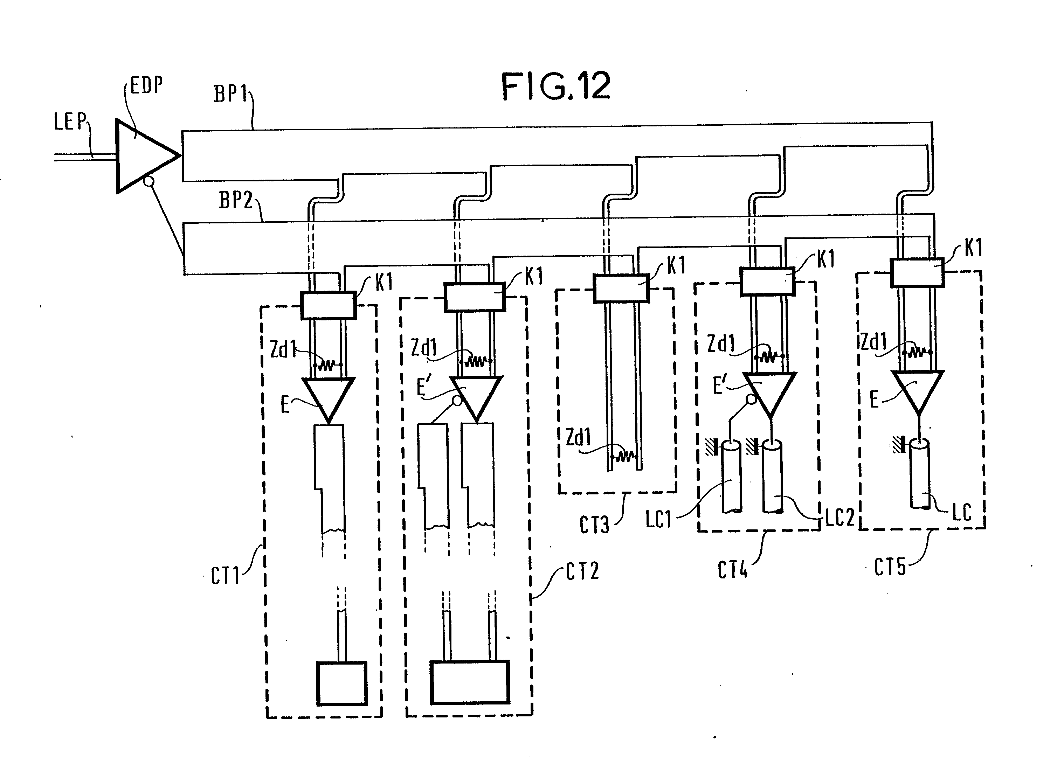

Dans les figures 1 à 4, les signaux numériques sont distribués à des dispositifs électroniques D1 à Dn, ou $D'1$ à $D'n$. Ces dispositifs électroniques sont soit des circuits dans lesquels sont exploités les signaux reçus, soit des circuits de transmission comportant chacun un émetteur E, ou $E'$, relié en sortie à un bus de distribution, ou à une ligne coaxiale ou bifilaire blindée par exemple, bien entendu dans les figures 1 à 4 certains dispositifs peuvent être des circuits et d'autres être des circuits de transmission. Le cas où tous les dispositifs électroniques sont des circuits de transmission correspond par exemple à une carte de fond de panier qui distribue auxdits circuits de transmission les signaux numériques qu'elle reçoit, comme décrit plus loin en regard des figures 11 et 12.

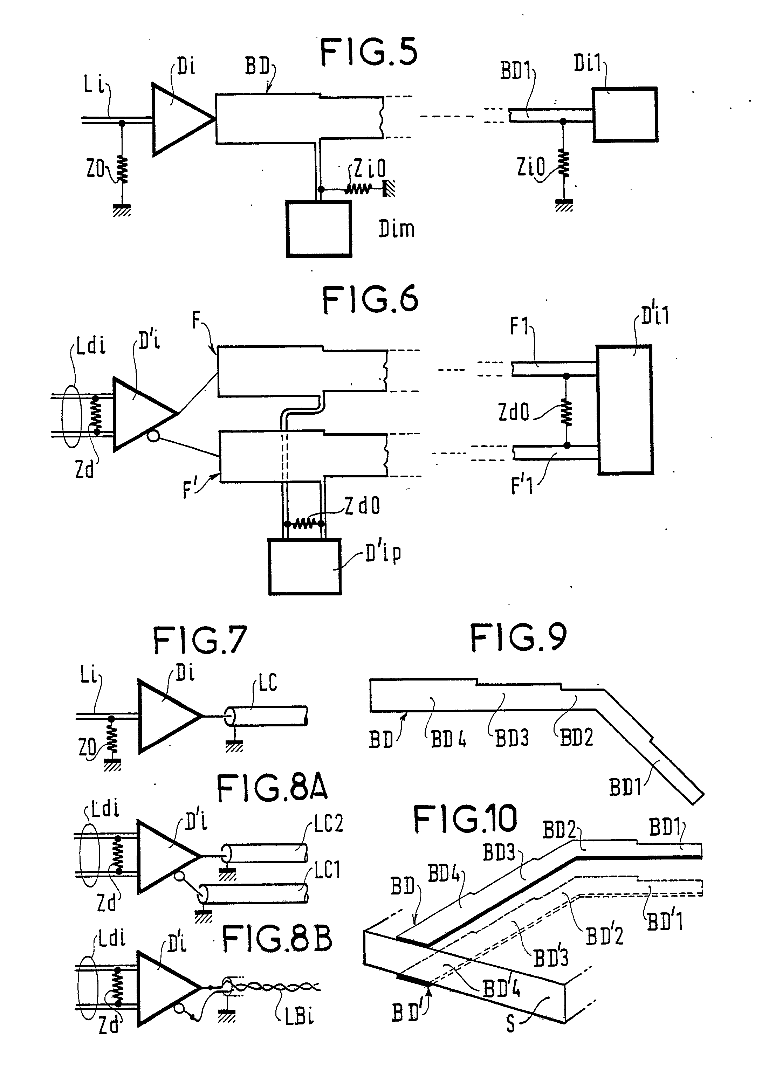

Dans la figure 5, les références Li et Di désignent une ligne et un dispositif électronique des figures 1 et 2 ; ce dispositif électronique est ici un émetteur relié en sortie à un bus de distribution BD ayant m tronçons reliés à des dispositifs électroniques Di1 à Dim, le tronçon BD1 étant fermé sur une impédance Zio égale à l'impédance caractérique dudit tronçon. Les dispositifs électroniques tels que Dim sont reliés par des lignes au bus BD, ces lignes ayant des longueurs quelconques et même impédance caractéristique, de valeur Zio par exemple ; elles sont donc fermées sur leur impédance caractéristique.

Dans la figure 6, Ldi et $D'i$ désignent une ligne différentielle et un dispositif électronique des figures 3 et 4 ; ce dispositif électronique est ici un émetteur différentiel relié en sortie à deux bus de distribution F et $F'$ ayant chacun p tronçons, F1 à Fp et $F'1$ à $F'p$, reliés à des dispositifs électroniques $D'i1$ à $D'ip$, le dispositif électronique $D'i1$ étant relié aux extrémités des tronçons F1 et $F'1$ des deux bus F et $F'$, les autres dispositifs électroniques, tels que $D'ip$, étant reliés par une ligne différentielle aux tronçons homologues des deux bus F et $F'$. Les lignes différentielles, de longueur quelconque et de même impédance sont fermées sur une impédance Zdo égale à leur impédance caractéristique ; les extrémités des tronçons F1 et $F'1$ sont reliées par une impédance Zdo en supposant que la ligne constituée par la paire de tronçons F1 et $F'1$ a une impédance égale à Zdo.

Dans la figure 7 les références Li et Di désignent une ligne et un dispositif électronique de la figure 1 ; ce dispositif électronique est ici un émetteur relié à un câble coaxial LC.

Dans les figures 8A et 8B, Ldi et $D'i$ désignent une ligne différentielle et un dispositif électronique des figures 3 et 4 ; ce dispositif électronique est ici un émetteur différentiel relié en sortie à deux câbles coaxiaux LC1 et LC2, figure 8A ou à une paire bifilaire blindée LBi, figure 8B.

Dans les figures 5 et 7 l'émetteur pourrait être un émetteur différentiel et dans ce cas, il serait relié, dans la figure 5 à deux bus identiques, et dans la figure 7 à deux câbles coaxiaux ou à une paire bifilaire blindée. De même dans les figures 6 et 8A, 8B, l'émetteur peut être un émetteur relié à un seul bus, ou à un seul câble coaxial, pour une distribution asymétrique.

Le bus d'une distribution asymétrique, ou les deux bus d'une distribution différentielle, peuvent ne pas être droits, et être coudés, selon un angle quelconque, afin de permettre une bonne utilisation de la carte de circuit imprimé pour l'implantation des dispositifs électroniques. La figure 9 représente un bus BD pour distribution asymétrique, présentant un coude dans le deuxième tronçon BD2.

La figure 10 représente les deux bus BD et $BD'$ d'une distribution différentielle, présentant chacun un coude dans le deuxième tronçon BD2, $BD'2$, respectivement. Dans le cas d'une distribution différentielle, les deux bus seront de préférence superposés, mais bien évidemment isolés l'un de l'autre par exemple par un substrat S, afin que les deux fils de chaque ligne différentielle aient la même longueur et que les tronçons homologues des bus soient en regard afin que l'impédance de chaque paire de tronçons homologues soit bien définie.

Les figures 11 et 12 sont relatives à une distribution en fond de panier, la figure 11 illustrant une distribution asymétrique et la figure 12 illustrant une distribution symétrique.

Dans la figure 11, une carte fond de panier comporte un émetteur EP et un bus de distribution BP relié en sortie de l'émetteur, lui même relié en entrée à une ligne LEP, différentielle ou non. Dans cette figure on a représenté un bus avec un côté longitudinal rectiligne, comme le bus C de la figure 2, mais bien entendu le bus BP pourrait avoir des jonctions obtenues par variation symétrique de la largeur des tronçons, comme dans la figure 1. Chaque jonction est reliée par l'intermédiaire d'un connecteur K à des circuits de transmission ; à titre d'exemples on a représenté différents circuits de transmission, CD1, CD2, CD4, CD5. Le circuit de transmission CD1 est du type représenté figures 1 et 2 ; le circuit de transmission CD2 est du type représenté figures 3 et 4 ; le circuit de transmission CD4 est constitué par un émetteur différentiel E' relié en sortie à deux câbles coaxiaux LC1, LC2, qui peuvent être remplacés par une ligne bifilaire blindée ; le circuit de transmission CD5 est du type représenté figure 5 ; il est relié par un connecteur K au tronçon extrême du bus BP. Dans les circuits de transmission CD1, CD2, CD4, CD5, les émetteurs sont reliés au bus de distribution BP par des lignes de dérivation de longueurs quelconques et de même impédance caractéristique ZO1. Le circuit CD3 est un circuit bouchon, relié également par un connecteur K à une jonction du bus BP, et comportant uniquement une ligne fermée sur son impédance caractéristique ZO1 qui est la même que celles des lignes des circuits de transmission ; ce circuit bouchon permet de conserver l'impédance du bus BP à la jonction correspondante, soit lorsque le circuit de transmission normalement reliée à ladite jonction est en panne, soit encore lorsqu'il n'est pas prévu de relier ladite jonction à un circuit de transmission.

Dans la figure 12 une carte fond de panier comporte un émetteur différentiel EDP et deux bus de distribution BP1 et BP2 ayant chacun un côté rectiligne comme dans la figure 4, mais bien entendu ils peuvent être du type des bus B et B' de la figure 3. Chaque paire de jonction des bus BD1 et BD2 est reliée par l'intermédiaire d'un connecteur K1 à des circuits de transmission ; à titre d'exemples on a représenté différents circuits de transmission CT1, CT2, CT4, CT5. Le circuit de transmission CT1 est du type représenté figures 1 et 2, dans lesquelles la ligne entrante LE est une ligne différentielle ; le circuit de transmission CT2 est du type représenté figures 3 et 4 dans lesquelles la ligne entrante LE est une ligne différentielle ; le circuit de transmission CT4 est du type représenté figure 8A, les deux câbles coaxiaux pouvant être remplacés par une ligne bifilaire blindée, comme représenté figure 8B ; le circuit de transmission CT5 est du type représenté figure 7 ; il est relié par un connecteur K1 aux deux tronçons extrêmes des bus BP1 et BP2. Dans les circuits de transmission CT1, CT2, CT4, CT5 les émetteurs sont reliés aux deux bus de distribution BP1 et BP2 par des lignes différentielles de longueurs quelconques et de même impédance caractéristique Zd1. Le circuit CT3 est un circuit bouchon, relié également par un connecteur K1 aux deux bus BP1 et BP2, et comportant une ligne différentielle fermée sur son impédance caractéristique Zd1 égale à celle des lignes différentielles des circuits de transmission ; ce circuit bouchon joue le même rôle que le circuit bouchon CD3 de la figure 11.

Dans les figures 11 et 12 les circuits de transmission et les circuits bouchons sont portés par des cartes de circuit imprimés. Les différents circuits représentés sont uniquement donnés à titre d/exemples, mais bien entendu tous les circuits de transmission peuvent être identiques, d'un type quelconque ; de même les circuits de transmission peuvent être d'un ou plusieurs des types représentés et le circuit bouchon peut ne pas exister, s'il n'y a pas de circuit de transmission en panne.

## Revendications

1/ Dispositif de distribution de signaux numériques à très hauts débits, comportant une ligne de distribution reliée à une extrémité à un émetteur (2) et des lignes en dérivation ayant même impédance caractéristique et reliées chacune à un dispositif électronique, la ligne de distribution étant constituée par au moins un bus d'impédance variable, le bus étant constitué de n tronçons (B1 à Bn) d'impédances différentes, chaque tronçon ayant une largeur constante, la largeur des tronçons successifs diminuant depuis l'extrémité du bus reliée à l'émetteur, chaque changement de largeur entre deux tronçons successifs constituant une jonction, et chaque ligne (L2 à Ln) en dérivation étant reliée à une jonction, caractérisé par le fait que les lignes (L2, L3,...Ln) en dérivation ont des longueurs quelconques et que les tronçons des bus ont des longueurs quelconques (Z1 à Zn).

2/ Dispositif de distribution selon la revendication 1, caractérisé par le fait que la ligne de distribution est constituée par deux bus (B, B') identiques, parallèles, pour une distribution différentielle, les deux bus étant reliés à une extrémité à un émetteur différentiel, que les lignes en dérivation sont des lignes différentielles (Ld2 à Ldn) de longueurs quelconques, que les tronçons homologues des deux bus sont en regard, deux tronçons homologues constituant une paire de tronçons et les paires de tronçons ayant des impédances différentes (Z1d à Znd), que chaque ligne différentielle (Ld2 à Ldn) est reliée d'une part à deux jonctions homologues des bus et d'autre part à un dispositif électronique (D2 à Dn) en entrée duquel elle est fermée sur son impédance caractéristique (Zd), qu'une paire de tronçons extrêmes (B1) des bus, à l'opposé de l'émetteur différentiel, est reliée en extrémité à un dispositif électronique (D1) en entrée duquel elle est fermée sur une impédance égale à l'impédance de ladite paire de tronçons extrêmes.

3/ Dispositif de distribution selon la revendication 2, caractérisé par le fait qu'à chaque jonction les tronçons sont raccordés entre eux de chaque côté des tronçons.

4/ Dispositif de distribution selon la revendication 2, caractérisé par le fait qu'un bus a un côté longitudinal rectiligne et que deux tronçons successifs sont raccordés entre eux par un autre côté desdits tronçons.

5/ Dispositif de distribution selon la revendication 2, caractérisé par le fait que les deux bus ont chacun un côté longitudinal rectiligne, que deux tronçons successifs de chaque bus sont raccordés entre eux par un autre côté desdits tronçons, et que les côtés longitudinaux rectilignes des deux bus sont en regard.

6/ Dispositif de distribution selon la revendication 2, caractérisé par le fait qu'un bus est droit.

7/ Dispositif de distribution selon la revendication 2, caractérisé par le fait que les deux bus sont superposés et isolés entre eux.

8/ Dispositif de distribution selon la revendication 2, caractérisé par le fait que les bus sont coudés dans leur longueur, selon un angle quelconque, les coudes étant situés dans des endroits homologues des bus.

9/ Dispositif de distribution selon la revendication 8, caractérisé par le fait que les bus sont superposés et isolés entre eux.

10/ Dispositif de distribution selon la revendication 1, caractérisé par le fait que la ligne de distribution est un bus de distribution (BP) d'un fond de panier, que chaque ligne en dérivation et le dispositif électronique associé constituent une carte de circuit imprimé (CD1), chaque ligne en dérivation étant reliée à une jonction du bus par un connecteur (K) et que le tronçon extrême du bus est relié par un connecteur (K) à un dispositif électronique porté par une carte de circuit imprimé (CD5).

11/ Dispositif de distribution selon la revendication 4, caractérisé par le fait que les deux bus de distribution constituent une ligne de distribution de fond de panier, que chaque ligne différentielle de dérivation et le dispositif électronique associé constituent une carte de circuit imprimé (CT1), chaque ligne différentielle étant reliée à deux jonctions homologues des bus par un connecteur (K1), et que les tronçons extrêmes des bus sont reliés par un connecteur (K1) à un dispositif électronique porté par une carte de circuit imprimé (CT5).

12/ Dispositif de distribution selon l'une des revendications 10 et 11, caractérisé par le fait qu'une carte de circuit imprimé défectueuse est remplacée par une carte bouchon (CD3 ; CT3) comportant uniquement une ligne fermée sur son impédance caractéristique.

# FIG.1

# FIG.2A

# FIG.2B

FIG.3

FIG.4

EP 0 340 713 A1

**FIG.5**

**FIG.6**

**FIG.7**

**FIG.9**

**FIG.8A**

**FIG.10**

**FIG.8B**

# FIG.11

EP 0 340 713 A1

# FIG.12

EP 0 340 713 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-3 593 174  (WHITE) <br> * Colonne 2, ligne 48 - colonne 3, ligne 23; colonne 3, ligne 63 - colonne 4, ligne 75; figures 1,2 * | 1 | H 01 P    5/12 |
| Y | | 2 | |
| A | | 4-6,10, 11 | |
| | --- | | |
| Y | EP-A-0 196 098  (HONEYWELL INC.) <br> * Page 7, ligne 1 - page 9, ligne 27; figures 3,4 * | 2 | |
| | --- | | |
| X | IRE TRANSACTIONS ON MICROWAVE THEORY AND TECHNIQUES, vol. MTT-3, no. 2, mars 1955, pages 157-162; D.J. SOMMERS: "Slot array employing photoetched tri-plate transmission lines" <br> * Page 159, colonne de gauche, lignes 5-33; figure 7 * | 1 | |
| A | IDEM | 4,6,10, 11 | DOMAINES TECHNIQUES RECHERCHES (Int. Cl.4) |
| | --- | | |
| A | ELECTRONICS LETTERS, vol. 21, no. 21, 10 octobre 1985, pages 950-951, Stevenage, Herts, GB; H.Q. TSERNG et al.: "10-30 GHz monolithic GaAs travelling-wave divider/combiner" <br> * Page 950; colonne de droite, lignes 20-25; figure 1 * | 3 | H 01 P <br> H 01 Q <br> H 03 F <br> H 03 H |
| | --- | | |
| A | JOURNAL I.E.E., vol. 4, no. 37, janvier 1958, pages 22-24; J.M.C. DUKES: "Microwave printed circuits" <br> * Figure 1a * | 7,9-11 | |
| | ----- | | |

Le présent rapport a été établi pour toutes les revendications

| Lieu de la recherche | Date d'achèvement de la recherche | Examinateur |
|---|---|---|
| LA HAYE | 12-07-1989 | DEN OTTER A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P0402)